# EUROPÄISCHE PATENTSCHRIFT

(11) **EP 1 976 006 B1**
(45) Veröffentlichungstag und Bekanntmachung des Hinweises auf die Patenterteilung: **05.07.2017**
(21) Anmeldenummer: 08005104.8
(22) Anmeldetag: 19.03.2008
(51) Int. Cl.: H05K 3/00, H05K 3/20, H05K 1/03

(54) **Systemträgerband für elektronische Bauteile**
System carrier tape for electronic components
Bande de support de système pour composants électroniques

(30) Priorität: 30.03.2007 DE 102007015817
(43) Veröffentlichungstag der Anmeldung: 01.10.2008
(73) Patentinhaber: Heraeus Deutschland GmbH & Co. KG, 63450 Hanau (DE)
(72) Erfinder: Ditzel, Eckhard, 63589 Linsengericht (DE); Ditzel, Reinhard, 63589 Linsengericht (DE); Benedikt, Michael, 63543 Neuberg (DE)
(74) Vertreter: Heraeus IP

(56) Entgegenhaltungen:
- EP-A- 0 533 137
- FR-A- 2 875 995
- JP-A- 1 154 545
- US-A1- 2002 064 907
- US-B1- 6 670 222

## Beschreibung

Die vorliegende Erfindung betrifft Laminate aus mit wiederkehrenden Strukturen strukturierten Folien, insbesondere Bänder, deren Strukturen zur Bestückung mit elektronischen Bauteilen vorgesehen sind. Diesbezüglich ist aus der Dimpling-Technik bekannt, Prägungen in Metallbändern mit einem umlaufenden Wulst zu versehen um damit auf der Oberfläche haftende Stoffe zu verankern.

Die DE 10 2005 044 001 beschreibt ein Verfahren zur Herstellung laminierter Substrate für die Halbleiter-Chipmontage mit jeweils unterschiedlichen, sich wiederholenden Konturen aufweisenden Metall- und Kunststofffolien.

EP 0 533 137 und US 2002/0064907 offenbaren weiteren relevanten Stand der Technik. Die Aufgabe der vorliegenden Erfindung besteht darin, einen verbesserten Halt von Stoffen auf ebenen laminierten Substraten zu erreichen.

Zur Lösung der Aufgabe werden zwei unterschiedlich strukturierte Folien, insbesondere Bänder so übereinander angeordnet, dass dünner strukturierte Bereiche der einen Folie von einer anderen Folie beabstandet gehalten werden, die zu diesen gerichtete Öffnungen aufweist, Maßgeblich ist hierbei, dass die dünneren Bereiche der ersten Folien teilweise von der anderen Folie überbrückt sind. Auf diese Weise wird eine robuste Verankerung eines Stoffs auf dem laminierten Substrat ermöglicht.

Die beiden miteinander laminierten unterschiedlich strukturierten Folien, insbesondere Bänder bestehen aus organischem Material, insbesondere Kunststoffen oder anorganischem Material, insbesondere Metall oder keramischem Werkstoffen.

Wiederkehrende strukturierte Bereiche der der Folien werden so zueinander angeordnet, dass sie miteinander Kavitäten innerhalb des Laminats ausbilden. Eine Kavität des Laminats weist als wiederkehrende Struktur einer Folie einen bezüglich der Foliendicke reduzierten Bereich auf und als wiederkehrende Struktur der anderen Folie ein Loch. Die Kavität wird durch teilweises Überbrücken des in der Foliendicke reduzierten Bereichs mit dem um das Loch verbleibenden Randbereich der anderen Folie gebildet. Der die Kavität begrenzende Randbereich um das zur Kavität gehörende Loch ist von dem in der Foliendicke reduzierten Bereich der anderen Folie beabstandet. Maßgeblich ist hierbei, dass die dünneren Bereiche der einen Folien nur teilweise von der anderen Folie überbrückt sind. Auf diese Weise wird eine robuste Verankerung eines Stoffs auf dem laminierten Substrat ermöglicht.

Es hat sich bewährt, die Tiefe der Einprägung bzw. Ausnehmung in gleicher Größenordnung zu dimensionieren, wie die Länge des überbrückten Bereichs, insbesondere in einem Verhältnis der Tiefe der Ausnehmung bzw. der Einprägung zur Tiefe des Hinterschnitts von 3:7 bis 7:3, vorzugsweise 4:6 bis 6:4.

Die dünner strukturierten Bereiche, insbesondere Einprägungen oder Ausnehmungen, haben sich im Bereich einer Dicke von 5 bis 80% der Foliendicke bewährt, insbesondere im Bereich einer Dicke von 10 bis 60 %.

Vorzugsweise wird jedem dünnem Bereich einer Folie mindestens ein Loch der gelochten Folie zugeordnet.

Besonders stabile Verankerungen sind erzielbar, wenn die Überbrückungen und Öffnungen in gleicher Größenordnung dimensioniert sind, insbesondere das Verhältnis der Fläche der Öffnungen zur Fläche der Überbrückungen im Bereich 3:7 bis 7:3 ausgebildet ist. Die Lösung der Aufgabe ist in Anspruch 1 beschrieben, bevorzugte Ausführungen in den abhängigen Ansprüchen.

Ein Systemträgerverbund, insbesondere Systemträgerband für elektronische Bauteile aus aufeinander laminierten jeweils unterschiedlich wiederkehrende Strukturen aufweisenden Bändern weist erfindungsgemäß ein erstes Band mit wiederkehrenden Strukturen in Form dünner Bereiche auf, insbesondere Einprägungen oder Ausnehmungen, wobei die dünnen Bereiche von einem zweiten Band unter Ausbildung von Kavitäten hinter Öffnungen im zweiten Band überbrückt sind.

Es hat sich weiterhin bewährt, das Verhältnis der Tiefe der Aussparung bzw. Einprägung zur verbleibenden Filmdicke in der gleichen Größenordnung auszuführen, insbesondere im Verhältnis 3:7 bis 7:3, vorzugsweise 4:6 bis 6:4.

Wiederkehrende Kavitäten entstehen erfindungsgemäß beim Laminieren dadurch, dass ein Band dünne Bereiche aufweist, die nicht laminiert werden und das andere Band Löcher aufweist, die Öffnungen zu den Räumen zwischen diesen dünnen Bereichen des einen Bandes und deren Überbrückung durch das andere Band bilden.

Ein Laminat mit wiederkehrenden Kavitäten, die zwischen zwei unterschiedlich strukturierten Bändern ausgebildet sind und zu einer Seite hin gerichtete Öffnungen aufweisen, wird erfindungsgemäß durch Laminieren eines Löcher aufweisenden Bandes mit einem Band, welches auf die Banddicke bezogen verjüngte Bereiche insbesondere Einprägungen oder Aussparungen aufweist geschaffen, indem die verjüngten Bereiche des einen Bandes teilweise mit dem anderen Band überbrückt werden. Maßgeblich ist hierbei, dass die nicht überbrückten Teile der verjüngten Bereiche mit den Löchern der anderen Folie zu Öffnungen ausgebildet werden.

Ein Systemträgerband für elektronische Bauteile aus aufeinander laminierten, jeweils unterschiedlich wiederkehrende Strukturen aufweisenden Bändern, weist erfindungsgemäß ein erstes Band auf, dessen wiederkehrende Strukturen dünnere Bereiche aufweisen, insbesondere Einprägungen oder Ausnehmungen, wobei die dünnen Bereiche von einem zweiten Band unter Ausbildung von Hohlräumen an Öffnungen im zweiten Band überbrückt sind.

Im Folgenden wird die Erfindung anhand von Beispielen mit Bezug auf eine Zeichnung verdeutlicht.
- Abbildung 1 ist eine Zeichnung eines Querschnitts eines Laminats mit einem in einer Hinterschneidung verankerten Adhäsivtropfen.
- Abbildung 2 ist eine Zeichnung eines Querschnitts eines Laminats mit einem in Minidimplings verankerten Adhäsivtropfen.
- Abbildung 3 ist eine Zeichnung eines Querschnitts eines Laminats mit einem durch einen Steg verankerten Adhäsivtropfen.

### Beispiel 1

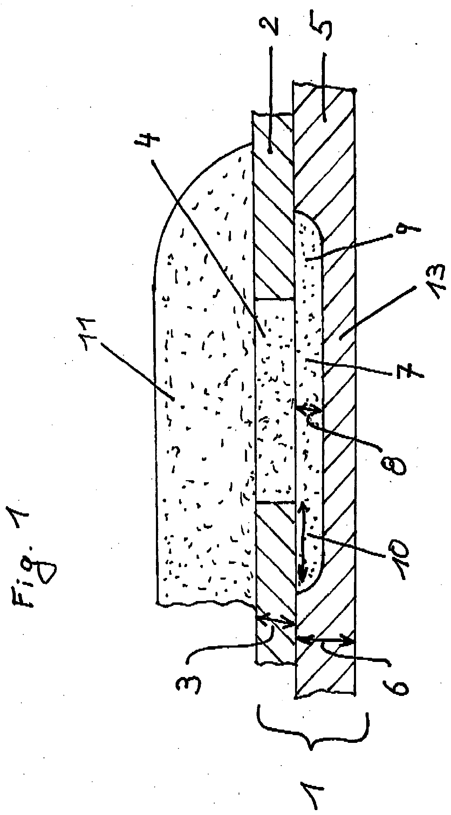

Ein Laminat 1 nach Fig. 1 aus einer geprägten Metallfolie 5 und einer gestanzten Kunststofffolie 2 weist zentrisch über Einprägungen 7 der Metallfolie angeordnete Stanzlöcher 4 der gestanzten Kunststofffolie 2 auf. Die flächige Ausdehnung des Stanzloches 4 ist in etwa halb so groß wie die flächige Ausdehnung der Einprägung 7. Hieraus ergibt sich als Überbrückung 3 eine Hinterschneidung 9, deren Länge 10 in der Größenordnung der Tiefe 8 der Einprägung liegt Damit bedeckt der Rand der gestanzten Folie 2 an den Stanzlöchern 4 die Randzonen der Einprägungen 7 der mit der gestanzten Folie 2 laminierten geprägten Folie 5.

Auf dem Laminat 1 wird ein Adhäsivtropfen 11 durch das Stanzloch 4 in der Einprägung 7 durch die Hinterschneidung 9 verankert.

### Beispiel 2

Ein Laminat 1 nach Fig. 1 aus einer gestanzten Kunststofffolie 2 und einer Metallfolie 5 weist Aussparungen 7 in der Metallfolie auf, über denen die Stanzlöcher 4 der Kunststofffolie 2 zentrisch angeordnet sind und der um die Stanzlöcher 4 der Kunststofffolie 2 befindliche Rand der Kunststofffolie 2 den Randbereich der Aussparung 7 abdeckt. Zum Randbereich der Aussparung 7 sind ggfs. noch kleine Öffnungen 4 in der Kunststofffolie angeordnet. Die kleinen Öffnungen 4 erleichtern das Verankern eines Adhäsivtropfen in der Aussparung durch Luftaustritt durch die kleinen Öffnungen 4, während die Aussparung mit Adhäsiv 11 befüllt wird.

### Bespiel 3

Ein Verbund 1 aus einer gestanzten Metallfolie 2 und einer Kunststofffolie 5 weist Ausnehmungen 7 in der Kunststofffolie auf, über denen Stanzlöcher 4 der Metallfolie 2 angeordnet sind.

### Beispiel 4

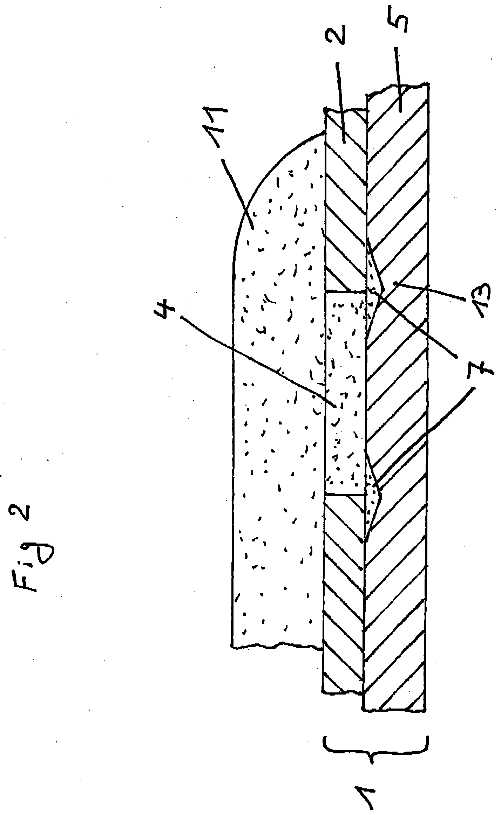

Nach Fig. 2 wird eine mit Minidimplings 7 versehene Metallfolie 5 mit einer gelochten Kunststofffolie laminiert wobei die Lochkanten der Kunststofffolie die Minidimplings 7 teilweise abdecken.

### Ausführungsform der Erfindung

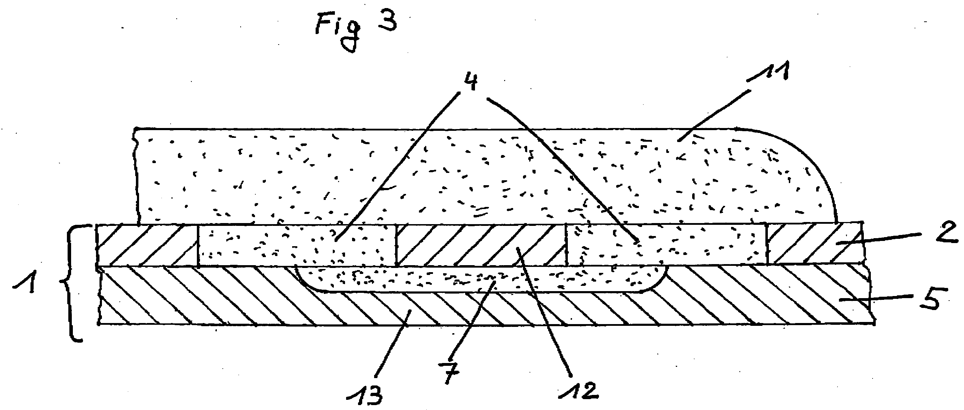

Nach Fig. 3 wird eine geprägte Metallfolie 5 mit einer gelochten Kunststofffolie 2 so laminiert, dass mehrere Löcher 4 im Randbereich der Einprägung der Metallfolie angeordnet werden. Die Einprägung 7 ist dabei mittig von der Kunststofffolie 2 überdacht. Die Dimensionierung der Löcher 4 und des Stegs 12 zwischen den Löchern 4 entspricht derselben Größenordnung, insbesondere einem Verhältnis von 3:7 bis 7:3.

## Patentansprüche

1. Laminat (1) aus zwei unterschiedlich strukturierten Folien (2, 5),
wobei
in dem Laminat (1) wiederkehrende Kavitäten innerhalb der beiden unterschiedlich strukturierten Folien (2, 5) ausgebildet sind,
wobei eine erste Folie (2) Öffnungen (4) aufweist und eine zweite Folie (5) verjüngte Bereiche (13) aufweist,
die Kavitäten aus Öffnungen (4) der ersten Folie (2) gebildet sind, welche verjüngte Bereiche (13) der zweiten Folie (5) überbrücken, die bezogen auf eine Foliendicke (6) der zweiten Folie (5) verjüngt sind und
die Öffnungen (4) der ersten Folie (2) so angeordnet sind, dass die verjüngten Bereiche (13) der zweiten Folie (5) nur teilweise mit den Öffnungen (4) der ersten Folie (2) überbrückt sind,
**dadurch gekennzeichnet, dass**
mehrere Öffnungen (4) in der ersten Folie (2) derart in einem Randbereich eines verjüngten Bereiches (7) in der zweiten Folien (5) angeordnet sind, dass der verjüngte Bereich (7) mittig von einem Steg (12) der ersten Folie (2) überdacht ist.

2. Laminat nach Anspruch 1, **dadurch gekennzeichnet, dass** eine Dimensionierung der Öffnungen (4) und des Stegs (12) zwischen den Löchern (4) einem Verhältnis von 3:7 bis 7:3 entspricht.

3. Verwendung eines Laminats (1) nach Anspruch 1 oder 2 als Systemträgerband für elektronische Bauteile.

## Claims

1. Laminate (1) made of two differently structured films (2, 5),
whereby
repeating cavities are formed in the laminate (1) within the two differently structured films,
whereby a first film (2) comprises openings (4) and a second film (5) comprises tapered regions (13),
the cavities are formed from openings (4) of the first film (2) which bridge tapered regions (13) of the second film (5), which are tapered with respect to a film thickness (6) of the second film (5), and
the openings (4) of the first film (2) are arranged appropriately such that the tapered regions (13) of the second film (5) are bridged only partially by the openings (4) of the second film (2),
**characterised in that**
multiple openings (4) in the first film (2) are arranged appropriately in an edge region of a tapered region (7) in the second films (5) such that the tapered region (7) is roofed in the middle by a fin (12) of the first film (2).

2. Laminate according to claim 1, **characterised in that** a dimensioning of the openings (4) and of the fin (12) between the holes (4) corresponds to a ratio of 3:7 to 7:3.

3. Use of a laminate (1) according to claim 1 or 2 as system carrier tape for electronic components.

## Revendications

1. Stratifié (1) composé de deux films (2, 5) différemment structurés,
dans lequel
des cavités récurrentes sont formées à l'intérieur des deux films (2, 5) différemment structurés dans le stratifié (1),
dans lequel un premier film (2) présente des ouvertures (4) et un second film (5) des zones amincies (13),
les cavités sont formées par des ouvertures (4) du premier film (2) qui comblent des zones amincies (13) du second film (5) qui sont amincies par rapport à une épaisseur (6) de film du second film (5) et
les ouvertures (4) du premier film (2) sont ainsi disposées que les zones amincies (13) du second film (5) ne sont comblées que partiellement par les ouvertures (4) du premier film (2),
**caractérisé en ce que**
plusieurs ouvertures (4) dans le premier film (2) sont disposées dans une zone de bord d'une zone amincie (7) dans le second film (5) de telle façon que la zone amincie (7) est recouverte au centre par une âme (12) du premier film (2).

2. Stratifié selon la revendication (1), **caractérisé en ce qu'**un dimensionnement des ouvertures (4) et de la branche (12) entre les trous (4) correspond à un rapport de 3:7 à 7:3.

3. Emploi d'un stratifié (1) selon la revendication 1 ou 2 en tant que bande porteuse de système pour des composants électroniques.
